# EUROPÄISCHE PATENTSCHRIFT

(11) **EP 0 632 850 B1**
(45) Veröffentlichungstag und Bekanntmachung des Hinweises auf die Patenterteilung: **09.07.1997**
(21) Anmeldenummer: 93902037.6
(22) Anmeldetag: 21.01.1993
(51) Int. Cl.: C23C 16/40, C23C 16/50

(54) **VERBUNDKÖRPER UND DESSEN VERWENDUNG**
COMPOSITE BODY AND ITS USE
CORPS COMPOSITE ET SON UTILISATION

(30) Priorität: 27.03.1992 DE 4209975
(43) Veröffentlichungstag der Anmeldung: 11.01.1995
(73) Patentinhaber: Widia GmbH, 45145 Essen (DE)
(72) Erfinder: KÖNIG, Udo, D-4300 Essen 1 (DE); VAN DEN BERG, Hendrikus, NL-5925 BT Venlo-Blerick (NL); TABERSKY, Ralf, D-4250 Bottrop (DE)
(74) Vertreter: Vomberg, Friedhelm, Dipl.-Phys.
(86) Internationale Anmeldenummer: DE9300047
(87) Internationale Veröffentlichungsnummer: WO9320257

(56) Entgegenhaltungen:
- EP-A- 0 408 535
- WO-A-90/06380
- WO-A-90/08613
- THIN SOLID FILMS Bd. 189, 1. August 1990, LAUSANNE Seiten 161 - 173 , XP151022 C.J. KANG, J.S. CHUN 'PROPERTIES OF ALUMINIUM OXIDE FILMS PREPARED BY PLASMA-ENHANCED METAL-ORGANIC CHEMICAL VAPOUR DEPOSITION'
- THIN SOLID FILMS Bd. 200, 1. Mai 1991, LAUSANNE Seiten 19 - 32 , XP206769 A. KWATERA 'CARBON-DOPED ALPHA-AL2O3 FILMS SYNTHESIZED ON CEMENTED CARBIDE TOOLS BY THE METAL ORGANIC LPCVD TECHNIQUE'
- JAPANESE JOURNAL OF APPLIED PHYSICS Bd. 11, Nr. 6, Juni 1972, TOKYO Seiten 840 - 848 K. IIDA, T. TSUJIDE 'PHYSICAL AND CHEMICAL PROPERTIES OF ALUMINIUM OXIDE FILM DEPOSITION BY ALCL3-CO2-H2 SYSTEM'
- WO-A-92/17623

## Beschreibung

Die Erfindung betrifft einen Verbundkörper, bestehend aus einem Keramik-oder Sinterkeramik-Substratkörper oder einem Substratkörper aus Diamant mit einer oder mehreren Oberflächenschichten und dessen Verwendung.

Bereits in der DE 22 33 700 C2 wird vorgeschlagen, Hartmetall-Substratkörper, die aus einem Gemisch aus wenigstens einem als Bindemittel dienenden Metall und wenigstens einem Metallcarbid von hoher Härte bestehen, mit einer aus Aluminiumoxid oder Zirkoniumoxid bestehenden Beschichtung zu versehen. Der Substratkörper kann insbesondere aus Wolfram-, Titan-, Tantal- oder Niobcarbid oder einem Mischcarbid aus Tantal und Niob bestehen, wobei als Bindemittel beispielsweise die Metalle Cobalt, Eisen oder Nickel dienen. Vielfach werden in der Literatur auch Hartmetalle auf der Basis von Titancarbid oder Titancarbonitrid als Cermets bezeichnet, die ebenso als Substratwerkstoff verstanden werden sollen wie reine Kombinationen eines Hartmetalles mit keramischen, also nicht metallischen Bestandteilen. Die erwähnten Schichten aus α-Aluminiumoxid werden nach der DE 22 33 700 C2 mittels CVD bei Substrattemperaturen von 1000°C aufgetragen.

Entsprechendes gilt für die Hartmetallkörper nach der DE 22 53 745 A1, die aus einem gesinterten Hartmetallsubstratkörper, einer Zwischenschicht aus Titancarbid und einer äußeren Schicht aus Aluminiumoxid bestehen, wobei die erste Titancarbid-Zwischenschicht bei 1000°C und die zweite Aluminiumoxid-Schicht bei 1100°C mittels des CVD-Verfahrens aufgebracht werden soll. Wie insbesondere in der DE 28 25 009, Spalte 2, Zeilen 28 ff., ausgeführt wird, sind harte, polykristalline und kompakte α-Aluminiumoxid-Schichten normalerweise nur bei Ablagerungstemperaturen oberhalb von 950°C herzustellen. Bei niedrigeren Ablagerungstemperaturen werden nach dem Stand der Technik lose und pulverförmige Ablagerungen erhalten, die aus der γ-Modifikation und/oder der ϑ-Modifikation des Aluminiumoxids bestehen. Bei Ablagerungstemperaturen von etwa 1000°C und darüber jedoch ist die Aluminiumoxidphase normalerweise die für die Beschichtung von Werkzeugen als geeignet angesehene χ-Modifikation. Um der Gefahr zu begegnen, mehrphasige Aluminiumoxid-Beschichtungen zu erhalten, die angeblich bei niedrigeren Abscheidetemperaturen als 1000°C auftreten und die eine erhebliche mechanische Schwäche und deshalb der Grund für vorzeitige Werkzeugfehler seien, wird vorgeschlagen, daß die Aluminiumoxid-Beschichtung ganz oder zu wenigstens 85 % aus der χ-Modifikation besteht und daß ein ggf. aus der α-Modifikation bestehende Rest auf der Oberfläche Bereiche bzw. Flecke mit einer Größe von höchstens 10 µm bildet. Zur Abscheidung wird das CVD-Verfahren bei Temperaturen von ca. 1000°C vorgeschlagen. Jedoch neigt diese Beschichtung bei der Einwirkung von hohen Temperaturen zu einer Umwandlung in die α-Modifikation, so daß dadurch in der Schicht Risse entstehen, die insbesondere bei Einwirkung von Heißgaskorrosionen zu vorzeitigem Versagen führen.

Um die bei hohen Abscheidetemperaturen entstehenden Probleme zu vermeiden, wird in der DE 32 34 943 beschrieben, eine amorphe Aluminiumoxid-Schicht aufzutragen. Eingehende Versuche mit amorphen Aluminiumoxid-Schichten, die mittels PVD abgeschieden worden sind, zeigten jedoch, daß rein amorphe AluminiumoxidSchichten ein glasartiges Bruchverhalten haben und somit keine signifikante Verbesserung im Verschleißverhalten ergeben können. Bei unterbrochenen Schnitten neigen diese Schichten zum Absplittern.

In der DE 24 28 530 Al wird ein Verfahren zum Schutz eines Metallteiles gegen Korrosion und Verschleiß vorgeschlagen, das in reinem oder legiertem Zustand mindestens ein zur Gruppe I B des periodischen Systems der Elemente gehörendes Element enthält und bei dem auf die Oberfläche dieses Teiles eine Schicht aus amorphem und durchsichtigem Aluminiumoxid durch chemische Abscheidung aus der Dampfphase aufgebracht ist. Die bei Temperaturen zwischen 300 und 800°C aufgebrachten amorphen Schichten sind jedoch gegen thermische Einwirkungen weit weniger stabil als beispielsweise die als korund bekannte Modifikation des Aluminiumoxids (α-Al₂O₃).

Grundsätzlich ist es auch bekannt, Aluminiumoxidschichten als Schutzschichten gegen Heißgaskorrosion einzusetzen, z.B. in Verbrennungskraftmaschinen. In diesem Falle sind neben der mechanischen Stabilität der Beschichtung auch besondere Anforderungen an die Dichtheit der Schicht zu stellen. Nach dem Stand der Technik kann dies nur durch vergleichsweise (ca. 500 µm) dicke, durch thermisches Spritzen hergestellte Keramikschichten erreicht werden.

Aus der nachveröffentlichten WO 92/17 623 Stand der Technik nach EPÜ, Art.54 Abs.3 ist ein aus einem Hartmetall-, Stahl- oder Cermet-Substratkörper oder einem Substratkörper aus einer Nickel- oder Cobaltbasislegierung und einer oder mehreren Oberflächenschichten, von denen mindestens eine, vorzugsweise die äußere, aus α-Al₂O₃ besteht, bekannt. Keramik-, Sinter-keramik oder Diammant- Substratkörper werden jedoch nicht erwähnt.

Es daher Aufgabe der vorliegenden Erfindung, den eingangs genannten Verbundkörper hinsichtlich der Schutzwirkung und der mechanischen Verschleißeigenschaften zu verbessern.

Diese Aufgabe wird durch den Verbundkörper nach Anspruch 1 gelöst, der aus einem Keramik- oder Sinterkeramik-Substratkörper oder einem Substratkörper aus Diamant und mindestens einer Aluminiumoxid-Oberflächenschicht besteht, die eine feinkristalline Struktur aufweist und die mittels eines Plasma-CVD-Verfahrens bei Substrattemperaturen von 400 bis 750°C, vorzugsweise 450°C bis 550°C, mit einer an dem als Kathode geschalteten Substratkörper mit einer gepulsten Gleichspannung herbeigeführten Plasmaaktivierung aufgetragen worden ist.

Die Aluminiumoxidschicht besteht aus feinkristallinem α-Al₂O₃ und/oder γ-Al₂O₃ mit einer Korngröße ≤50 nm oder aus diesen Modifikationen mit Anteilen von amorphem Aluminiumoxid.

Dieser Verbundkörper hat gegenüber anderen Verbundkörpern mit Beschichtungen, die mittels PVD- oder CVD-Beschichtungsverfahren aufgetragen worden sind, erhebliche Vorteile. Insbesondere bei Stählen scheidet das CVD-Beschichtungsverfahren, das bei hohen Temperaturen durchgeführt werden muß, aus, da aufgrund der notwendigen hohen Beschichtungstemperatur das Hartgefüge des Stahles verlorengeht, so daß nach dem Beschichten eine Vergütung durchzuführen wäre, was den Nachteil einer Verschlechterung der Maßgenauigkeit hat. Das PVD-Verfahren, das bei niedrigen Temperaturen durchgeführt werden kann, hat hingegen den Nachteil, daß bei komplizierten Formteilen Vertiefungen und Sacklöcher nicht hinreichend gleichmäßig beschichtet werden können. Diese Schattierungseffekte lassen sich auch durch Rotieren der eingespannten Teile beim Beschichten kaum vermeiden.

Überraschenderweise zeigen die erfindungsgemäßen Aluminiumoxidschichten ein gänzlich anderes Verhalten, was nur ihrer feinkristallinen Struktur zugeschrieben werden kann. Gegenüber den anderen theoretisch möglichen Beschichtungen mit Titannitrid, Titancarbid oder Titancarbonitrid besitzt Aluminiumoxid in seinen α- und/oder γ-Modifikationen hervorragende Verschleißbeständigkeit.

Vorzugsweise ist die Verbundkörper-Beschichtung dergestalt, daß das Elektronenbeugungsbild der Beschichtung aus Aluminiumoxid Interferenzringe aufweist, die einzelnen Netzebenen von γ-Al₂O₃ und/oder α-Al₂O₃ zugeordnet werden können. Die beobachteten Interferenzmuster (Debye-Scherrer-Ringe) sind eindeutig einzelnen Netzebenen der betreffenden Kristallphasen zuzuordnen.

Vorzugsweise besitzt der Verbundkörper eine Beschichtung mit besonders feinkristalliner Struktur des Aluminiumoxids. Ein Maß für die Kristallgröße liefert das Röntgenbeugungsmethode. Die Linienbreiten der Interferenzlinien des Röntgenbeugungsdiagrammes sind bei Verwendung von CuK_{α} -Strahlung und unter gleicher Winkelstellung 2 θ des die Strahlung registrierenden Zählrohres und bei gleicher Apertur des Strahlenkollimators um so schmaler, je größer die interferierenden einkristallinen Kristallite oder je größer die mittlere Korngröße des polykristallinen Materials (z.B. von α-Aluminiumoxid) ist. Dieser Zusammenhang wird durch die von W. Scherrer abgeleitete Formel B_{1/2} = k · λ/(<d> · cosθ) beschrieben. λ ist die Wellenlänge der Röntgenstrahlung, <d> die mittlere lineare Ausdehnung des reflektierenden Kristallites, e der Glanzwinkel und k eine Konstante. Die Linienbreite der Röntgenbeugungsdiagramme kann somit insbesondere bei sehr feinen, submikroskopischen Kristallen als leicht zugängliches Maß für die mittlere Korngröße verwendet werden. Als Vergleichsgröße gilt die Halbwertsbreite der mit derselben Röntgenstrahlung gemessenen Beugungslinie bei Untersuchung eines pulverförmigen Körpers aus α-Al₂O₃ oder einer mit einem CVD-Verfahren bei 1000°C bis 1100°C aufgetragenen α-Al₂O₃-Schicht.

Vorzugsweise wird als Maß die durch die Miller-Indizes (113) indizierte und beim Beugungswinkel von 43,4° der 2θ-Skala bei CuK_{α} -Röntgenstrahlung auftretende Röntgenbeugungslinie zugrundegelegt, deren Halbwertsbreite, vorzugsweise mindestens vierfache Halbwertsbreite der entsprechenden Röntgenbeugungslinie von pulverförmigem Aluminiumoxid als Maß für die Feinkörnigkeit der hexagonal dicht gepackten Kristallstruktur des Aluminiumoxids zugrundegelegt.

Eine andere Nachweismethode für die besondere Feinkristallität der erfindungsgemäßen Beschichtung beruht auf der Elektronenbeugung in einem Elektronenmikroskop. Wenn die Größe der Kristallite wesentlich kleiner als der Durchmesser des Elektronenbündels ist (typisch sind Durchmesser von ca. 300 nm), entsteht ein Beugungsbild mit sogenannten Debye-Scherrer-Ringen. Aus den Wellenlängen der Elektronen und dem Durchmesser der Ringe kann man die Netzebenenabstände der Kristallite berechnen, die wiederum eindeutig bestimmten Kristallstrukturen zugeordnet werden können. Mit dieser Methode wurde festgestellt, daß die Schichten aus feinkristallinem α-Al₂O₃ oder γ-Al₂O₃ bestanden. in einigen Beschichtungen wurden auch beide Modifikationen festgestellt.

Nach einer Weiterbildung der Erfindung soll die Dicke der Aluminiumoxid-Beschichtung 0,5 bis 10 µm, vorzugsweise 1 bis 5 µm, Übetragen.

Nach einer weiteren Ausgestaltung der Erfindung besteht die Beschichtung aus Aluminiumoxid aus 49 bis 52,5 Massen-% Aluminium, 46 bis 47,5 Massen-% Sauerstoff und 0,5 bis 3,5 Massen-% Chlor.

Je nach Anwendungszweck haben sich auch Schutzschichten bewährt, die mit anderen Schichten aus Carbiden, Carbonitriden, Nitriden, Boriden und/oder Oxiden der Elemente der Gruppen IVa bis VIa des Periodensystems kombiniert wurden. Hiermit sind ausdrücklich Mehrlagenbeschichtungen aus Aluminiumoxid und Titancarbid sowie Titannitrid angesprochen.

Zur Herstellung der feinkörnigen Aluminiumoxid-Beschichtung wird erfindungsgemäß ein Plasma-CVD-Verfahren bei Substrattemperaturen von 400 bis 700°C angewendet, bei dem die Plasmaaktivierung an dem als Kathode geschalteten Substratkörper mit einer gepulsten Gleichspannung herbeigefügt wird. Die niedrigen Beschichtungstemperaturen durch Auswahl des Plasma-CVD-Verfahrens führen zu einer Verbesserung der Haftung der Aluminiumoxidoberflächenschicht. Der Substratkörper wird bis auf die Auflagepunkte vollständig und gleichmäßig von der Schicht bedeckt, ohne die ansonsten bei PVD-Verfahren auftretenden Abschattungseffekte. Vorzugsweise wird die Beschichtung jedoch bei Temperaturen zwischen 450 und 550°C durchgeführt. Die gepulste Gleichspannung hat Maximalwerte zwischen 200 und 900 V.

Die Qualität der Beschichtung wird weiterhin dadurch verbessert, daß zwischen den positiven Gleichspannungsimpulsen (Rechteckimpulsen) in den Pulspausen eine Restgleichspannung aufrechterhalten bleibt, die größer als das niedrigste Ionisierungspotential der am CVD-Prozeß beteiligten Gasmoleküle, jedoch nicht größer als 50 % des Maximalwertes der gepulsten Gleichspannung ist. Hierbei kommt es primär nicht auf den Spannungsverlauf bzw. die Gleichmäßigkeit der Restgleichspannung an, sondern lediglich darauf, daß über die gesamte Zeit zwischen zwei Rechteckimpulsen die Restgleichspannung stets größer als das genannte Ionisierungspotential ist. Im folgenden sind einige der für den CVD-Proze von Aluminiumoxid maßgeblichen Ionisierungspotentiale angegeben:
H: 13,5 eV, H₂: 15,8 eV,
Ar: 15,7 eV,
O : 13,6 eV, O₂ : 12,1 eV,
AlCl₃: 11,0 eV.

Vorzugsweise liegt das Verhältnis der Restgleichspannung zum Maximalwert der gepulsten Gleichspannung zwischen 0,02 und 0,5.

Die Periodendauer der gepulsten Gleichspannung soll vorzugsweise zwischen 20 µs und 20 ms liegen, wobei man unter der Periodendauer die Dauer eines Rechteckimpulses und einer Pulspause versteht. Vorzugsweise wird das Verhältnis der Pulsdauer zu der Periodendauer zwischen 0,1 bis 0,6 gewählt. Die Parameter werden schließlich so eingestellt, daß eine Schichtwachstumsgeschwindigkeit von 0,5 bis 10 µm/h erreicht wird.

Das geschilderte Verfahren zur Aluminiumoxid-Beschichtung ist zwar grundsätzlich bereits in der DE 38 41 730 A1 beschrieben und kann auch zur Beschichtung aus verschiedenen anderen Hartstoffen, wie Carbiden, Nitriden, Boriden, Siliciden und Oxiden mit einer besonders großen Härte und einem hohen Schmelzpunkt, also z.B. Titancarbid, Titannitrid, Titancarbonitrid, Zirkoniumoxid, Borcarbid, Siliciumcarbid und Titandiborid verwendet werden, jedoch war es überraschend, daß entgegen den in der zum Stand der Technik gehörenden Literatur geäußerten Befürchtungen die Schutzschichten eine unerwartet feinkörnige α- und/oder γ-Aluminiumoxid-Modifikation aufweisen.

Vorzugsweise wird als Hartstoff-bildende reaktive Gasatmosphäre Aluminiumchlorid, Kohlendioxid und Wasserstoff, die durch eine Glimmentladung teilweise ionisiert wird, verwendet. Als bevorzugten Gasdruck beim Beschichten werden 200 bis 400 Pascal eingestellt.

Der erfindungsgemäße Verbundkörper kann zu verschiedenen technischen Zwecken eingesetzt werden. Eine weitere Anwendung gründet sich auf der Dichtheit und der Oxidationsbeständigkeit der Schutzschicht. Da die durch das erfindungsgemäße Verfahren hergestellten Schichten Druckspannungen aufweisen, bleibt die Beschichtung auch bei hohen Temperaturen und der dadurch bedingten Ausdehnung des Grundkörpers noch dicht, d.h., es entstehen keine Risse. Die Schutzschicht ist daher hervorragend zur Auskleidung von Brennkammern geeignet.

Beim Extrudieren, das verfahrenstechnisch dem Spritzgießen ähnlich ist, wird in einem kontinuierlichen Fertigungsablauf Halbzeug, wie Profile, hergestellt. Die flüssige Formmasse wird durch ein Extrusionswerkzeug gepreßt, das regelmäßig eine einen Formraum begrenzende Düse oder Matrize sowie ggf. einen koaxial angeordneten Dorn besitzt. Insbesondere bei der Verarbeitung von Aluminium oder Aluminiumlegierungen zu Profilen hat sich das Extrudieren bewährt. Anders als beim vorbeschriebenen Gießen ist es jedoch beim Extrudieren nicht möglich, Trennmittel an den Werkzeugen, die bisher meist aus Stahl gefertigt sind, anzubringen. Somit wurde insbesondere an Stahlwerkzeugen, die mit dem Extrusionsgut unmittelbar in Berührung kommen, ein Verschleiß, in Einzelfällen auch ein Verkleben in Kauf genommen, was mit der erfindungsgemäßen Beschichtung vermieden werden kann.

Weiterbildungen der Erfindung und sich gegenüber dem Stand der Technik ergebende Vorteile werden im folgenden anhand von Zeichnungen erläutert. Es zeige
- Fig. 1: Gefüge der Beschichtung eines mit feinkristallinem α-Al₂O₃ beschichteten Grundkörper - hier aus Hartmetall -; rasterelektronenmikroskopische Aufnahme, Vergrößerung 8000 : 1,
- Fig. 2: das Linienprofil einer nach dem Stand der Technik bekannten kompakten Aluminiumoxidprobe,
- Fig. 3: das Linienprofil einer a-Aluminiumoxid-Schutzschicht auf einem Stahlsubstrat,
- Fig. 4: Elektronenbeugungsbild einer erfindungsgemäßen γ-Al₂O₃-Schicht.

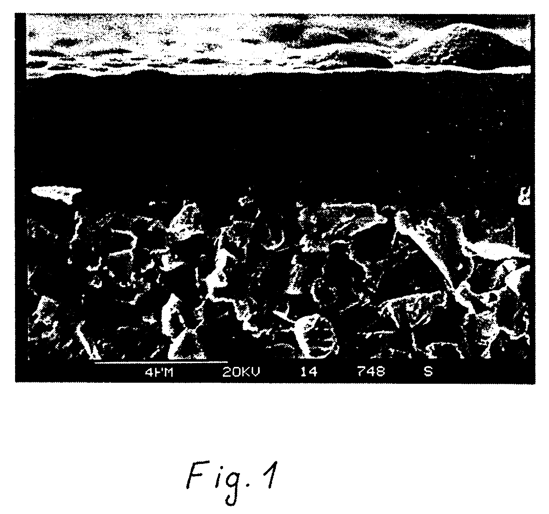

Das abgeschiedene Aluminiumoxid hat eine sehr feinkörnige Gefügestruktur. Durch Untersuchungen mit einem Raster-Elektronenmikroskop kann diese Gefügestruktur sichtbar gemacht werden. Wie Fig. 1 zeigt, weist die erfindungsgemäße Schutzschicht ein sehr feines, poren- und rißfreies Gefüge auf.

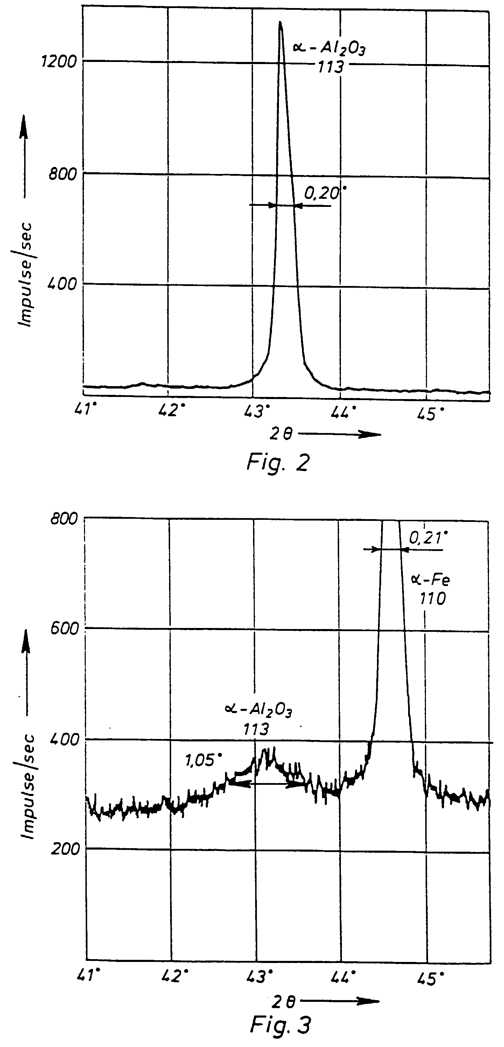

Vorausgeschickt werden soll zu der Erläuterung der Fig. 2 und 3 die Bemerkung, daß jede Kristallstruktur, wie z.B. das α-Al₂O₃ oder das γ-Al₂O₃ bei bestimmten Beugungswinkeln 2 Θ, die durch die sogenannten Miller-Indizes gekennzeichneten Interferenzlinien zeigt. Zum Beispiel treten bei γ-Al₂O₃ bei anderen Beugungswinkeln 2 Θ als bei α-Al₂O₃ jeweils strukturspezifische Interferenzlinien auf, so daß ein Röntgenbeugungsdiagramm als eine Art Fingerabdruck für die Identifizierung von Kristallstrukturen und den Modifikationen eines festen Stoffes angesehen werden kann.

Wie bereits oben erwähnt, stehen die Halbwertsbreiten in unmittelbarem proportionalen Zusammenhang zu der mittleren Größe des reflektierenden Kristalles.

Fig. 2 zeigt einen Ausschnitt aus dem Linienprofil eines kompakten Aluminiumoxid-Körpers. Die Halbwerts-Linienbreite des (113)-Reflexes beträgt 0,2° der 2 Θ-skala bei Verwendung von CuK_{α}-Strahlung.

Hingegen beträgt die Halbwertsbreite der α-Al₂O₃-Linie des (113)-Reflexes einer hergestellten Probe 1,05° der 2 Θ-Skala (siehe Bild 3). Verbundkörper mit der erfindungsgemäßen feinkristallinen α-Al₂O₃-Beschichtung haben somit eine Linienbreite, die mindestens um das Dreifache, im vorliegenden Fall das Fünffache der bei Kompaktkörpern (siehe Fig. 2) entstehenden natürlichen Linienbreite beträgt.

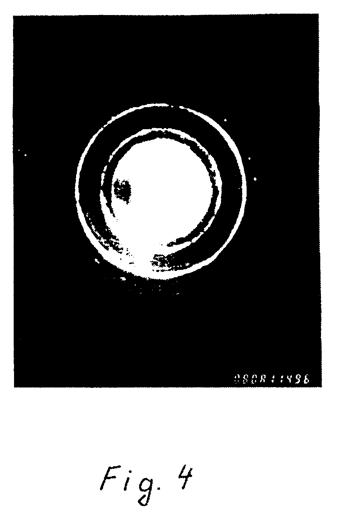

Fig. 4 zeigt ein Elektronenbeugungsbild einer erfindungsgemäßen Schicht. Aus den Durchmessern der Beugungsringe wurden die in der folgenden Tabelle aufgeführten Netzebenenabstände d_{obs} bestimmt.

| Index nkl | d_{obs} nm | d_{calc} nm |
|---|---|---|
| 311 | 0,2393 | 0,2384 |
| 400 | 0,1979 | 0,1977 |
| 511, 333 | 0,1525 | 0,1522 |
| 440 | 0,1398 | 0,1398 |
| 622 | 0,1192 | 0,1192 |
| 444 | 0,1137 | 0,1142 |
| 800 | 0,0986 | 0,0988 |

Mit Hilfe der aus der Literatur bekannten Gitterkonstante des γ -Al₂O₃ (a = 0,7908 nm) wurden die Netzebenenabstände berechnet (d_{calc}) und den beobachteten d_{obs} gegenübergestellt. Die gute Übereinstimmung von d_{obscalc} beweist, daß die aufgetragene Schicht aus der Modifikation γ-Al₂O₃ besteht.

## Patentansprüche

1. Verbundkörper, bestehend aus einem Keramik-oder Sinterkeramik-Substratkörper oder einem Substratkörper aus Diamant und einer oder mehreren Oberflächenschichten, von denen mindestens eine, vorzugsweise die äußere, aus feinkristallinem γ-Al₂O₃ und/oder α-Al₂O₃ mit einer Korngröße ≤50 nm oder aus diesen Modifikationen mit Anteilen von amorphem Al₂O₃ besteht, das mittels eines Plasma-CVD-Verfahrens bei Substrattemperaturen von 400°C bis 750°C, vorzugsweise 450° bis 550°C, mit einer an dem als Kathode geschalteten Substratkörper mit einer gepulsten Gleichspannung herbeigeführten Plasmaaktivierung aufgetragen worden ist.

2. Verbundkörper nach Anspruch 1, dadurch gekennzeichnet, daß das Elektronenbeugungsbild der Beschichtung aus Aluminiumoxid Interferenzringe aufweist, die einzelnen Netzebenen von γ-Al₂O₃ oder α-Al₂O₃ zugeordnet werden können.

3. Verbundkörper nach einem der Ansprüche 1 oder 2, dadurch gekennzeichnet, daß das α-Al₂O₃ eine feinkristalline Struktur aufweist, deren durch die Halbwertsbreiten der mit CuK_{α}-Röntgenstrahlung gemessenen Beugungslinien eine mindestens dreimal so große Halbwertsbreite wie die eines pulverförmigen Kompaktkörpers aus α-Al₂O₃ oder einer mit einem CVD-Verfahren bei 1000°C bis 1100°C aufgetragenen α -Al₂O₃ -Schicht aufweisen.

4. Verbundkörper nach einem der Ansprüche 1 bis 3, dadurch gekennzeichnet, daß die durch die Miller-Indizes (113) indizierte und beim Beugungswinkel 43,4° der 2 Θ-Skala bei CuK_{α}-Röntgenstrahlung auftretenden Röntgenbeugungslinie mindestens die dreifache, vorzugsweise mindestens die vierfache Halbwertsbreite der entsprechenden Röntgenbeugungslinie von pulverförmigen α-Al₂O₃ aufweist.

5. Verbundkörper nach einem der Ansprüche 1 bis 4, dadurch gekennzeichnet, daß die Dicke der Al₂O₃-Beschichtung 0,5 bis 10 µm beträgt.

6. Verbundkörper nach einem der Ansprüche 1 bis 5, dadurch gekennzeichnet, daß die Beschichtung aus Al₂O₃ aus 49 bis 52,5 Massen-% Aluminium, 46 bis 47,5 Massen-% Sauerstoff und 0,5 bis 3,5 Massen-% Chlor besteht.

7. Verbundkörper nach einem der Ansprüche 1 bis 6, gekennzeichnet durch eine oder mehrere weitere Schichten aus Carbiden, Carbonitriden, Nitriden, Boriden und/oder Oxiden der Elemente Ti, Zr, Hf, V, Nb, Ta, Cr, Mo oder W.

8. Verbundkörper nach Anspruch 7, dadurch gekennzeichnet, daß mindestens eine Schicht aus TiC und/oder TiN besteht.

9. Verbundkörper nach Anspruch 7 oder 8, dadurch gekennzeichnet, daß die an den Substratkörper angrenzende Schicht eine Aluminiumoxidschicht nach den Ansprüchen 1 bis 6 ist.

10. Verwendung des Verbundkörpers nach einem der Ansprüche 1 bis 10 als Schneidstoff zur spanabhebenden Bearbeitung, als Hochtemperaturwerkstoff, vorzugsweise in Brennkammern oder als verschleißfester Werkstoff für aneinanderreibende Teile, insbesondere Nockenwellen oder als Urformwerkzeug, insbesondere Gießform oder Extrusionswerkzeug.

## Claims

1. Composite body consisting of a ceramic or sintered ceramic substrate body or a substrate body made of diamond and of one or more surface layers, of which at least one, preferably the outer layer, consists of fine crystalline γ-Al₂O₃ and/or α-Al₂O₃ with a grain size ≤50 nm, or of their modifications with fractions of amorphous Al₂O₃, which has been applied by means of a plasma CVD process at substrate temperatures of 400°C to 750°C, preferably 450°C to 550°C, with a substrate body connected as cathode and with a plasma activation produced with a pulsed direct voltage.

2. Composite body according to claim 1, characterized in that the electron diffraction pattern of the aluminum oxide coating shows interference rings which can be attributed to singular lattice planes of γ-Al₂O₃ or α-Al₂O₃.

3. Composite body according to one of claim 1 or 2, characterized in that the α-Al₂O₃ has a fine crystalline structure, whose diffraction lines measured via CuK_{α}-radiation by way of half-value widths, have a half-value width at least by three times bigger than in the case of a powdery compact body of α-Al₂O₃ or of an α-Al₂O₃ layer applied through a CVD process at 1000°C to 1100°C.

4. Composite body according to one of claim 1 to 3, characterized in that the X-ray diffraction line indexed via the Miller indices (113) and occurring at the diffraction angle 43.4° of the 2 θ scale when CuK_{α} radiation is used, is at least triple, preferably at least four times bigger than the half-value width of the corresponding X-ray diffraction line of the powdery α-Al₂O₃.

5. Composite body according to one of claim 1 to 4, characterized in that the thickness of the Al₂O₃ coating amounts to at least 0,5 to 10 µm.

6. Composite body according to one of claims 1 to 5, characterized in that the coating of Al₂O₃ consists of 49 to 52,5 % by mass aluminum, 46 to 47.5 % by mass oxygen and 0,5 to 3,5 % by mass chlorine.

7. Composite body according to one of claims 1 to 6, characterized by one or more layers of carbides, carbonitrides, nitrides, borides and/or oxides of the elements Ti, Zr, Hf, V, Nb, Ta, Cr, Mo or W.

8. Composite body according to claim 7, characterized in that at least one layer consists of TiC and/or TiN.

9. Composite body according to claim 7 or 8, characterized in that the layer bordering the substrate body is an aluminum oxide layer according to claims 1 to 6.

10. Use of the composite body according to one of claims 1 to 9 as a cutting material for chip-forming machining, as a high-temperature material, preferably for combustion chambers, or as a wear-resistant material for frictionally connected parts, particularly cam shafts, or as forming devices, particularly casting dies or extrusion tools.

## Revendications

1. Corps composite se composant d'un corps substrat en céramique ou céramique frittée ou d'un corps substrat en diamant et d'une ou de plusieurs couches superficielles dont l'une au moins, de préférence la couche superficielle extérieure, se compose de γ-Al₂O₃ et/ou de α-Al₂O₃ à fins cristaux ayant une grosseur de grain ≤50 nm, ou de ces modifications avec des fractions de Al₂O₃ amorphe, qui a été appliqué par l'intermédiaire d'un procédé CVD à plasma à des températures de substrat comprises entre 400°C et 750°C, de préférence entre 450°C et 550°C, avec une activation par plasma produite par une tension continue pulsée sur le corps substrat connecté en tant que cathode.

2. Corps composite selon la revendication 1, caractérisé par le fait que l'image de diffraction d'électrons du revêtement en oxyde d'aluminium présente des anneaux d'interférence qui peuvent être attribués à des plans réticulaires individuels de γ-Al₂O₃ ou α-Al₂O_{3.}

3. Corps composite selon l'une des revendications 1 ou 2, caractérisé par le fait que le α-Al₂O₃ présente une structure à fins cristaux dont les lignes de diffraction mesurées par le biais des largeurs de valeur moyenne des lignes de diffraction mesurées par le rayonnement X CuK_{α}, présentent une largeur de valeur moyenne qui est du moins trois fois plus grande que dans le cas d'un corps compact pulvérulent en α-Al₂O₃ ou d'une couche en α-Al₂O₃ appliquée par le biais d'un procédé CVD à une température comprise entre 1000°C et 1100°C.

4. Corps composite selon l'une des revendications 1 à 3, caractérisé par le fait que la ligne de diffraction à rayons X indiquée par les indices de Miller (113) et se produisant à l'angle de diffraction de 43,4° de l'échelle 2 Θ dans le cas d'un rayonnement X CuK_{α}, présente du moins la triple, de préférence du moins la quadruple largeur de valeur moyenne de la ligne correspondante de diffraction à rayons X de α-Al₂O₃ pulvérulent.

5. Corps composite selon l'une des revendications 1 à 4, caractérisé par le fait que l'épaisseur du revêtement en Al₂O₃ est comprise entre 0,5 et 10 µm.

6. Corps composite selon l'une des revendications 1 à 5, caractérisé par le fait que le revêtement en Al₂O₃ se compose de 49 à 52,5% en masse d'aluminium, de 46 à 47,5% en masse d'oxygène et de 0,5 à 3,5% en masse de chlore.

7. Corps composite selon l'une des revendications 1 à 6, caractérisé par une ou plusieurs d'autres couches en carbures, carbonitrures, nitrures, borures et/ou oxydes des éléments Ti, Zr, Hf, V, Nb, Ta, Cr, Mo ou W.

8. Corps composite selon la revendication 7, caractérisé par le fait que du moins une couche se compose de TiC et/ou de TiN.

9. Corps composite selon la revendication 7 ou 8, caractérisé par le fait que la couche adjacente au corps substrat est une couche en oxyde d'aluminium selon les revendications 1 à 6.

10. Utilisation du corps composite selon l'une des revendications 1 à 9 en tant que matériau de coupe pour l'usinage à enlèvement de copeaux, en tant que matériaux pour hautes températures, de préférence dans des chambres de combustion, ou en tant que matériau résistant à l'usure pour des pièces frottant l'une contre l'autre, en particulier pour des arbres à cames, ou comme outil de formage, en particulier moule ou outil d'extrusion.
